# EUROPEAN PATENT SPECIFICATION

(11) **EP 2 194 098 B1**
(45) Date of publication and mention of the grant of the patent: **15.08.2012**
(21) Application number: 08777703.3
(22) Date of filing: 30.06.2008
(51) Int. Cl.: C08L 63/00, B32B 15/08, C08G 59/40, C08J 5/24, H05K 1/03

(54) **EPOXY RESIN COMPOSITION, PREPREG USING THE EPOXY RESIN COMPOSITION, METAL-CLAD LAMINATE, AND PRINTED WIRING BOARD**
EPOXIDHARZZUSAMMENSETZUNG, PREPREG UNTER VERWENDUNG DER EPOXIDZUSAMMENSETZUNG, METALLUMHÜLLTES LAMINAT UND LEITERPLATTE
COMPOSITION DE RÉSINE ÉPOXY, PRÉIMPRÉGNÉ UTILISANT LA COMPOSITION DE RÉSINE ÉPOXY, STRATIFIÉ PLAQUÉ DE MÉTAL ET CARTE IMPRIMÉE

(30) Priority: 27.09.2007 WO PCT/JP2007/068873
(43) Date of publication of application: 09.06.2010
(73) Proprietor: Panasonic Corporation, Osaka 571-8501 (JP)
(72) Inventor: FUJIWARA, Hiroaki, Kadoma-shi Osaka 571-8501 (JP); IMAI, Masao, Kadoma-shi Osaka 571-8501 (JP); KITAI, Yuki, Kadoma-shi Osaka 571-8501 (JP)
(74) Representative: Müller-Boré & Partner Patentanwälte
(86) International application number: PCT/JP2008/061852
(87) International publication number: WO 2009/041137

(56) References cited:
- WO-A1-2004/029127
- JP-A- 8 245 871
- JP-A- 10 265 669
- JP-A- 10 279 781
- JP-A- 2003 224 367
- US-B2- 7 056 585

## Description

### Technical Field

The present invention relates to an epoxy resin composition to be used favorably as an insulating material for printed wiring boards. Specifically, it relates to an epoxy resin composition to be used favorably for manufacturing printed wiring boards having excellent heat resistance, to a prepreg using the epoxy resin composition, to a metal-clad laminate and to a printed wiring board.

### Background Art

Greater signal capacities and higher speeds have been achieved in recent years with electronic devices used in the information and communication fields. Consequently, there is demand for printed wiring boards with good high-frequency characteristics that are adaptable to high levels of multilayering to allow for an increased number of interconnections.

A low dielectric constant (ε) and low dielectric dissipation factor (tan δ) are required in order to ensure the reliability of a printed wiring board used in such an electronic device at high frequencies in the MHz and GHz bands. Conventionally, thermosetting resin compositions comprising polyphenylene ether (PPE) compounded with epoxy resin have been used for the insulating layers of printed wiring boards having such electrical characteristics. Such thermosetting resin compositions exhibit better dielectric characteristics than ordinary epoxy resin compositions. However, the problem is that they are less heat resistant than other expensive high-frequency substrate materials such as PTFE and other fluorine resins, BT resins, polyimide resins and the like.

In order to improve heat resistance, Patent Document 1 and Patent Document 2 below disclose epoxy resin compositions containing a specific epoxy compound, a reduced-molecular-weight phenol-modified polyphenylene ether and a cyanate compound as essential components. Such epoxy resin compositions have high heat resistance and excellent dielectric characteristics.

In addition to the aforementioned heat resistance and dielectric characteristics, the epoxy resin compositions used in the insulating layers of printed wiring boards also need to be highly flame retardant. A method widely used for conferring flame retardancy on such epoxy resin compositions is to compound a specific amount of a brominated epoxy compound as an epoxy resin component (see for example Patent Documents 1 to 4).

However, epoxy resin compositions such as those described above containing an epoxy compound, a low-molecular-weight phenol-modified polyphenylene ether and a cyanate compound as essential components have still been insufficiently heat resistant in comparison with other high-frequency substrate materials, despite their excellent dielectric characteristics.
Patent Document 1: Japanese Patent Application Laid-open No. H10-265669
Patent Document 2: Japanese Patent Application Laid-open No. 2000-7763
Patent Document 3: Japanese Patent Application Laid-open No. H9-227659
Patent Document 4: Japanese Patent Application Laid-open No. H11-302529

Document EP 1 550 678 A1 discloses a thermosetting resin composition composed of a resin varnish containing an epoxy compound containing at least two epoxy groups in the molecule without containing any halogen atoms, a polyphenylene ether, a cyanate ester compound, a curing catalyst and a halogen flame retardant, wherein the epoxy compound, the polyphenylene ether, the cyanate ester compound and the curing catalyst are dissolved in the resin varnish, while the flame retardant is dispersed in the resin varnish.

Document JP 8 245871 A discloses a curable polyphenylene ether resin composition containing a halogen flame retardant.

### Disclosure of the Invention

It is an object of the present invention to provide an epoxy resin composition comprising an epoxy compound, a low-molecular-weight phenol-modified polyphenylene ether and a cyanate compound as essential components, which is an epoxy resin composition having excellent dielectric characteristics and exhibiting high heat resistance while maintaining flame retardancy.

An epoxy resin composition of one aspect of the present invention that resolves this problem is a thermosetting resin composition composed of a resin varnish containing (A) an epoxy compound having a number-average molecular weight of 1000 or less and containing at least two epoxy groups in the molecule without containing any halogen atoms, (B) a polyphenylene ether having a number-average molecular weight of 5000 or less, (C) a cyanate ester compound, (D) a curing catalyst and (E) a halogen flame retardant, wherein all of the components (A) to (C) are dissolved in the resin varnish, while the component (E) is not dissolved but dispersed with an average particle diameter of 0.1 to 50µm in the resin varnish.

The objects, features, aspects and advantages of the present invention are made clear by the following detailed description.

### Best Mode for Carrying Out the Invention

As a result of an investigation for improving the heat resistance of an epoxy resin composition containing an epoxy compound, a reduced-molecular-weight phenol-modified polyphenylene ether and a cyanate compound, the inventors found that while heat resistance is reduced when the brominated epoxy compounds commonly used for flame retardancy in epoxy resin compositions are used in combination with cyanate compounds, heat resistance is greatly improved when no brominated epoxy compound is used. It was also found as a result of further investigations that when a brominated epoxy compound or other halogenated epoxy compound or a common halogen flame retardant is used with the aim of achieving a flame-retardant epoxy resin composition, halogens are dissociated at high temperatures to produce halogen ions (or halogen radicals), and these dissociated halogens break down the cured composition. It was also found as a result of exhaustive investigations aiming at maintaining the heat resistance of the cured composition that flameretardancy could be achieved without detracting from heat resistance by using a halogen flame retardant that was dispersed rather than being dissolved in a resin varnish. The present invention was perfected based on these findings.

An embodiment of the present invention is explained in detail below.

In the present embodiment, there are no particular limitations on the type of the epoxy compound (A) with a number-average molecular weight of 1000 or less containing at least two epoxy groups in the molecule and containing no halogen atoms. Specific examples include dicyclopentadiene epoxy compounds, bisphenol A epoxy compounds, bisphenol F epoxy compounds, phenol novolac epoxy compounds, naphthalene epoxy compounds, biphenyl epoxy compounds and the like. These may be used individually, or two or more may be used in combinations. Of these, the dicyclopentadiene epoxy compounds, bisphenol F epoxy compounds, bisphenol A epoxy compounds and biphenyl epoxy compounds are desirable from the standpoint of good compatibility with the polyphenylene ether. The thermosetting resin composition contains no halogenated epoxy compound.

From the standpoint of maintaining adequate heat resistance as well as excellent mechanical properties and electrical properties, the compounded proportion of the epoxy compound (A) in the epoxy resin composition of the embodiment is preferably 20 to 60 mass% or more preferably 30 to 50 mass% of the combined amount of the components (A) to (C).

In the embodiment, the polyphenylene ether (B) with a number-average molecular weight of 5000 or less may be obtained by a polymerization reaction, or may be obtained by a redistribution reaction in which PPE with a high molecular weight (specifically, a number-average molecular weight of about 10000 to 30000) is heated in toluene or another solvent in the presence of a phenol compound and a radical initiator.

The polyphenylene ether obtained by this redistribution reaction is desirable for ensuring still greater heat resistance because it has at both ends of the molecular chain the hydroxyl groups derived from the phenol compound that contribute to curing. On the other hand, the polyphenylene ether obtained by polymerization is desirable from the standpoint of superior fluidity.

The number-average molecular weight of the polyphenylene ether (B) is 5000 or less or preferably 2000 to 4000. If the number-average molecular weight exceeds 5000, fluidity declines, and heat resistance cannot be improved sufficiently because reactivity with epoxy groups is reduced and more time is required for the curing reaction, resulting in a lower glass transition temperature caused by more unreacted groups that are not incorporated into the cured system.

The molecular weight of the polyphenylene ether (B) can be adjusted by adjusting the compounded amount of the phenol compound used during the redistribution reaction. That is, the greater the compounded amount of the phenol compound, the lower the molecular weight.

A commercial product or other known compound can be used as the high-molecular-weight PPE in the redistribution reaction, and a specific example is poly(2,6-dimethyl-1,4-phenylene ether). The phenol compound used in the redistribution reaction is not particularly limited, but for example it is desirable to use a polyfunctional phenol compound having 2 or more phenolic hydroxyl groups in the molecule, such as bisphenol A, phenol novolac, cresol novolac or the like. These may be used individually, or two or more may be used in combination.

From the standpoint of adequately conferring superior dielectric characteristics, the compounded amount of the polyphenylene ether (B) in the epoxy resin composition of the embodiment is preferably 20 to 60 mass% or more preferably 20 to 40 mass% of the total amount of the components (A) to (C).

The cyanate ester compound (C) in the embodiment can be any having 2 or more cyanate groups in the molecule, without any particular limitations. Specific examples include 2,2-bis(4-cyanatophenyl)propane, bis(3,5-dimethyl-4-cyanatophenyl)methane, 2,2-bis(4-cyanatophenyl)ethane and the like, as well as derivates of these and aromatic cyanate ester compounds and the like. These may be used individually, or two or more may be used in combination.

The cyanate ester compound (C) is a compound that acts as a curing agent for the epoxy compound in forming the epoxy resin, and forms a rigid framework. Consequently, it confers a high glass transition temperature (Tg). Moreover, its low viscosity allows the resulting resin varnish to maintain high fluidity.

In the presence of the curing catalyst (D), the cyanate ester compound (C) undergoes self-polymerization also within the cyanate ester compound. In this self-polymerization reaction, cyanate groups react with each other to form triazine rings. This self-polymerization reaction also contributes to improved heat resistance.

The compounded amount of the cyanate ester compound (C) in the epoxy resin composition of the embodiment is preferably 20 to 60 mass% or more preferably 20 to 40 mass% of the total amount of the components (A) to (C) from the standpoint of obtaining adequate heat resistance and excellent impregnation of the substrate, while making it difficult for crystals to precipitate in the resin varnish.

The curing catalyst (D) in the embodiment is a catalyst that promotes the reaction of the epoxy compound (A) and the polyphenylene ether (B) with the cyanate ester compound (C) (the curing agent), and specific examples include Zn, Cu, Fe and other organic metal salts of organic acids such as octanoic acid, stearic acid, acetylacetonate, naphthenic acid, salicylic acid and the like as well as triethylamine, triethanolamine and other tertiary amines and 2-ethyl-4-imidazole, 4-methylimidazole and other imidazoles and the like. These may be used individually, or two or more may be used in combination. Of these, an organic metal salt and zinc octanoate in particular is especially desirable from the standpoint of obtaining high heat resistance.

The compounded proportion of the curing catalyst (D) is not particularly limited, but is preferably about 0.005 to 5 parts by mass per 100 parts by mass of the total amount of the components (A) to (C) when an organic metal salt is used for example, or about 0.01 to 5 parts by mass per 100 parts by mass of the total amount of the components (A) to (C) when an imidazole is used.

Halogen flame retardant (E) in the embodiment is not particularly limited as long as it is a halogen flame retardant that is insoluble in a varnish prepared with a toluene or other solvent. Such a halogen flame retardant that is insoluble in the varnish does not greatly detract from the heat resistance of the cured product because the flame retardant is present in particulate form in the matrix and is therefore less likely to lower the glass transition point (Tg) of the cured product or cause halogen dissociation. Specific examples of such halogen flame retardants include **ethylene dipentabromobenzene, ethylene bistetrabromophthalimide, decabromodiphenyl oxide, tetradecabromo diphenoxybenzene,** bis(tribromophenoxy)ethane and the like. Of these, ethylene dipentabromobenzene, ethylene **bistetrabromophthalimide,** decabromodiphenyl oxide and tetradecabromo diphenoxybenzene can be used by preference because they exhibit high heat resistance with melting points of 300°C or more. Using such a heat-resistant halogen flame retardant with a melting point of 300°C or more makes it possible to control halogen dissociation at high temperatures and prevent a reduction in heat resistance due to decomposition of the resulting cured product.

It is desirable from the standpoint of adequately maintaining heat resistance and interlayer insulation that the average particle diameter of the halogen flame retardant (E) in its dispersed state be 0.1 to 50 µm or more preferably 1 to 10 µm. This average particle diameter can be measured with a Shimadzu Corp. particle size analyzer (SALD-2100) or the like.

The compounded proportion of this halogen flame retardant (E) is preferably such as to obtain a halogen concentration of about 5 to 30 mass% of the total amount of the resin components (that is, components excluding inorganic components) in the resulting cured composition.

The inorganic filler (F) can also be added as necessary to the epoxy resin composition of the embodiment with the aim of increasing the dimensional stability during heating, increasing flame retardancy and the like.

Specific examples of the inorganic filler (F) include spherical silica and other silicas, alumina, talc, aluminum hydroxide, magnesium hydroxide, titanium oxide, mica, aluminum borate, barium sulfate, calcium carbonate and the like.

The inorganic filler (F) is preferably one that has been surface-treated with an epoxysilane or aminosilane type silane coupling agent. A metal-clad laminate obtained using the epoxy resin compounded with the inorganic filler that has been surface-treated with such a silane coupling agent has high heat resistance during moisture adsorption, and tends to have greater interlayer peel strength.

From the standpoint of improving dimensional stability without reducing fluidity and adhesiveness with metal foil, the compounded amount of the inorganic filler (F) is preferably 10 to 100 or more preferably 20 to 70 or still more preferably 20 to 50 parts by mass per total 100 parts by mass of the components (A) to (C).

Other components normally compounded with epoxy resin compositions, such as thermal stabilizers, antistatic agents, ultraviolet absorbers, flame retardants, dyes, pigments, lubricants and the like can be compounded with the epoxy resin composition of the embodiment of the present invention.

In the epoxy resin composition of the embodiment, the components (A) to (C) are each dissolved in the resin varnish, but the component (E) is dispersed rather than being dissolved in the resin varnish. Such a resin varnish is prepared as follows for example.

The epoxy compound (A) and the cyanate ester compound (C) are each dissolved in specific amounts in a resin solution of the polyphenylene ether (B) with a number-average molecular weight of 5000 or less, which is obtained by the redistribution reaction of high-molecular-weight PPE in toluene. Heating can also be used here as necessary. For purposes of dissolution, it is desirable to use the epoxy compound (A) and the cyanate ester compound (C) that are soluble in a toluene or other solvent at room temperature in order to avoid precipitates and the like in the resin varnish.

The halogen flame retardant (E) is then added together with the inorganic filler (F) as necessary, and dispersed to a specific dispersion state with a ball mill, bead mill, planetary mixer, roll mill or the like to prepare a resin varnish.

One method for preparing a prepreg using the resulting resin varnish is to impregnate a fibrous substrate with the resin varnish, which is then dried.

The fibrous substrate may be made of glass cloth, aramide cloth, polyester cloth, glass nonwoven cloth, aramide nonwoven cloth, polyester nonwoven cloth, pulp paper, Linter paper or the like. A laminate with excellent mechanical strength can be obtained with the glass cloth, and the glass cloth that has been flattened is especially desirable. Flattening can be accomplished by pressing the glass cloth continuously with a pressing roll at a specific pressure to compress the yarn in a flat shape. Ordinarily, a substrate with a thickness of 0.04 to 0.3 mm is used.

Impregnation is accomplished by dipping or applying the varnish. The impregnation operation can be repeated several times as necessary. In this case, impregnation can be repeated using multiple solutions with different compositions and concentrations to adjust the composition and resin volume as desired.

The substrate thus impregnated with the varnish is heated under the desired heating conditions, such as a time of 1 to 10 minutes at 80 to 170°C for example, to obtain a semi-cured (B-stage) prepreg.

In one method for preparing a metal-clad laminate using the prepreg thus obtained, one sheet or a stack of multiple sheets of the prepreg is covered on either the top or bottom or both with copper or other metal foil, and the layers are then laminated together by hot press molding to prepare a laminate plated on one or both sides with metal foil. The hot press conditions can be set appropriately according to the thickness of the laminate to be manufactured, the resin composition of the prepreg and the like, but a temperature of 170 to 210°C, a pressure of 3.5 to 4.0 Pa and a time of 60 to 150 minutes can be used for example.

In the curing reaction of the epoxy resin composition of the embodiment, the phenolic hydroxyl groups at the ends of the polyphenylene ether (B) react with the epoxy groups of the epoxy compound (A), and these in turn react with the cyanate ester compound (C) to form strong crosslinked structures. The cured product using the cyanate ester compound (C) has both excellent electrical characteristics and excellent heat resistance. Flame retardancy can be obtained while maintaining high heat resistance, because the halogen flame retardant that does not dissolve in the resin varnish is used to confer flame retardancy while using the epoxy compound containing no halogen atoms as the epoxy compound (A).

The metal foil on the surface of the laminate thus prepared can then be etched or the like to form circuits and produce a printed wiring board comprising the conductive pattern of circuits on the surface of the laminate. The resulting printed wiring board has excellent dielectric characteristics as well as high heat resistance and flame retardancy.

The present invention is explained in more detail below by means of examples, but the scope of the present invention is not limited by these examples.

### Examples

(Manufacturing Example 1: Manufacturing a solution of polyphenylene ether with a number-average molecular weight of 2500 (PPE1) by a redistribution reaction).
250 g of toluene was placed in a 2000 ml flask equipped with an agitation mechanism and an agitator blade. 90 g of high-molecular-weight PPE (PPE with a number average molecular weight of 25,000: Noryl 640-111 from Japan GE Plastics), 7 g of bisphenol A and 7 g of benzoyl peroxide were added with the flask maintained at an internal temperature of 90°C, and reacted by 2 hours of continuous agitation to prepare a solution (solids concentration 28 mass%) of polyphenylene ether with a number-average molecular weight of 2500 (PPE1). The number-average molecular weight was the value as styrene as measured by gel permeation chromatography (GPC).

(Manufacturing Example 2: Manufacturing a solution of polyphenylene ether with a number-average molecular weight of 2500 (PPE2) obtained by polymerization)
Japan GE Plastics SA120 (PPE with a number-average molecular weight of 2500) was dissolved in toluene at 80°C to prepare a solution (solids concentration 28 mass%) of polyphenylene ether with a number-average molecular weight of 2500.

(Manufacturing Example 3: Manufacturing a solution of polyphenylene ether with a number-average molecular weight of 4000 (PPE3))
A solution (solids concentration 28 mass%) of polyphenylene ether with a number-average molecular weight of 4000 (PPE3) was prepared by a reaction similar to that of Manufacturing Example 1 except that the amounts of bisphenol A and benzoyl peroxide were reduced to 3.6 g and 3.6 g, respectively.

### (Examples 1 to 11, Comparative Examples 1 to 4)

First, the raw materials used in these examples are summarized.

### (Epoxy compounds)

- Dicyclopentadiene epoxy compound, Epiclon HP-7200 (Dainippon Ink & Chemicals), number average molecular weight (Mn) 550
- Bisphenol F epoxy compound, Mn 350 Epiclon 830S (Dainippon Ink & Chemicals)
- Tetrabromobisphenol A epoxy compound, Mn 800 Epiclon 153 (Dainippon Ink & Chemicals)
- Bisphenol A epoxy compound, Mn 1500 Epiclon 3050 (Dainippon Ink & Chemicals)

### (Cyanate ester compounds)

- 2,2-bis(4-cyanatophenyl)propane (Lonza Japan BandCy)
- Cyanate ester compound represented by the following Formula (1) (Huntsman Japan XU366)

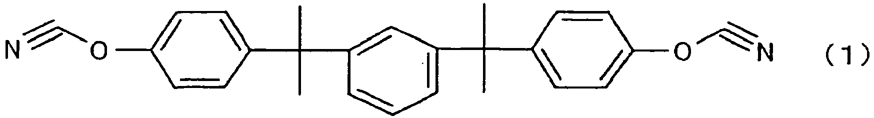

### (Flame retardants)

- Toluene-insoluble ethylenebis(pentabromophenyl) (Albemarle Japan Saytex 8010, melting point 350°C)
- Toluene-insoluble ethylenebistetrabromophthalimide (Albemarle Japan BT-93, melting point 456°C)
- Toluene-insoluble bis(tribromophenoxy)ethane (Great Lakes FF-680, melting point 225°C)
- Toluene-soluble tetrabromobisphenol A (Albemarle Japan Saytex CP-2000, melting point 181°C)
- Toluene-soluble brominated polystyrene (Albemarle Japan Saytex HP-7010, melting point 182°C)

### (Curing catalysts)

- Zinc octanoate (Dainippon Ink & Chemicals, zinc concentration 18%)
- 2-ethyl-4-methylimidazole (Shikoku Kasei 2E4MZ)

### (Inorganic fillers)

• Surface-untreated spherical silica (SiO₂) S025R (Admatechs)
• Surface-treated spherical silica A SC-2500-SEJ (treated with epoxysilane type silane coupling agent, Admatechs)
• Surface-treated spherical silica B SC-2500-GRJ (treated with epoxysilane type silane coupling agent, Admatechs)
• Surface-treated spherical silica C SC-2500-SXJ (treated with aminosilane type silane coupling agent, Admatechs)
• Surface-treated spherical silica D SC-2500-SVJ (treated with vinylsilane type silane coupling agent, Admatechs)
• Surface-treated spherical silica E SC-2500-SYJ (treated with acryloxysilane type silane coupling agent, Admatechs)

### (Preparation of vinyl varnish)

A toluene solution of the polyphenylene ether was heated to 90°C, and the epoxy compound and cyanate ester compound were added to the proportions shown in Table 1 and completely dissolved by 30 minutes of agitation. The curing catalyst, flame retardant and inorganic filler were then added and dispersed with a ball mill to obtain a resin varnish. In all of the examples the flame retardant was not dissolved but dispersed in the resin varnish with an average particle diameter of 1 to 10 µm.

Glass cloth (Nitto Boseki Co. WEA116E) was then impregnated with the resulting resin varnish, and heat dried at 150°C for 3 to 5 minutes to obtain a prepreg.

Each of the resulting prepregs was then laminated in stacks of 6 sheets, copper foil (Furukawa Circuit Foil Co. F2-WS, 18 µm) was placed over both outer layers, and the whole was hot pressed at temperature 220°C, pressure 3 MPa to obtain a 0.75 mm-thick copper-clad laminate.

The resulting prepregs and copper-clad laminates were evaluated as follows.

### (Fluidity evaluation of prepregs)

A core material 150 mm long, 100 mm wide and 0.8 mm thick was prepared having 1000 communicating holes 0.3 mm in diameter formed at intervals of 2 mm. The resulting prepreg and copper foil were then laminated in that order on one side of this core material, while only copper foil was laminated on the other side. This laminate was then molded by hot pressing under conditions of 220°C × 2 hours, pressure 3 MPa. The number of holes out of the 1000 that were completely filled was counted, and the percentage calculated.

### (Oven heat resistance)

A copper-clad laminate cut to a specific size in accordance with JIS C 6481 was left for 1 hour in a thermostatic tank set to a specific temperature, and then removed. The treated test piece was then observed visually to determine the maximum temperature at which no blisters occurred.

### (Heat resistance during moisture absorption)

A test piece prepared in accordance with JIS C 6481 was treated for 120 minutes in an autoclave at 121°C, 2 atmospheres, and then dipped for 20 seconds in a solder tank at 260°C, and evaluated as "good" if there was no blistering or peeling of the copper foil and laminate, or as "poor" if blistering or peeling occurred.

### (Flame retardancy)

The flame retardancy of a copper-clad laminate cut to a specific size was evaluated by the UL 94 flammability testing method.

### (Dielectric characteristics)

The dielectric constant and dielectric dissipation factor at 1 MHz were determined in accordance with JIS C 6481.

### (Thermal expansion coefficient)

The thermal expansion coefficient in the Z-axial direction was determined in accordance with JIS C 6481. The measurement conditions were program rate 5°C/minute, temperature range 75 to 125°C.

### (Interlayer adhesive strength)

Interlayer adhesive strength was measured in accordance with JIS C 6481.

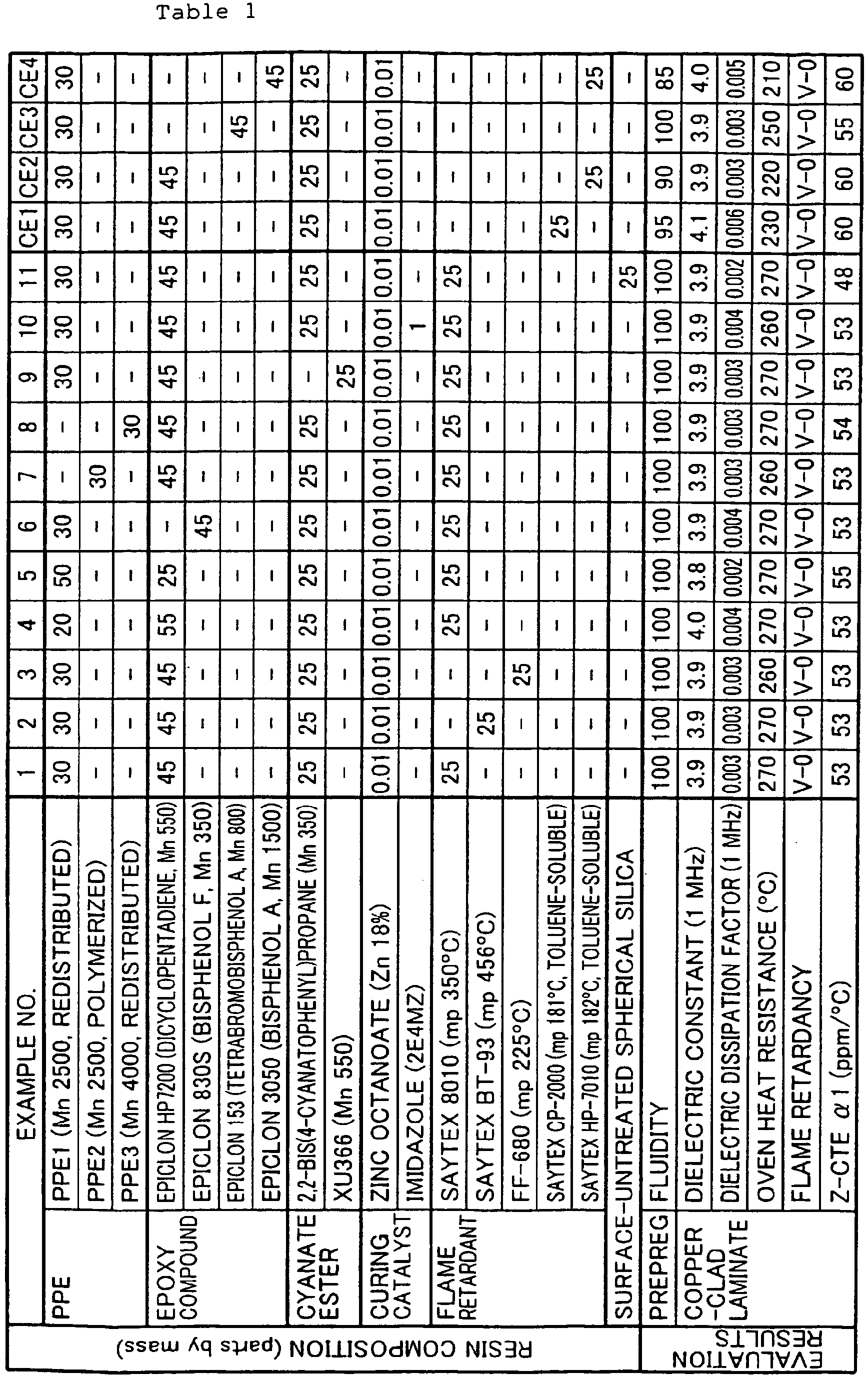

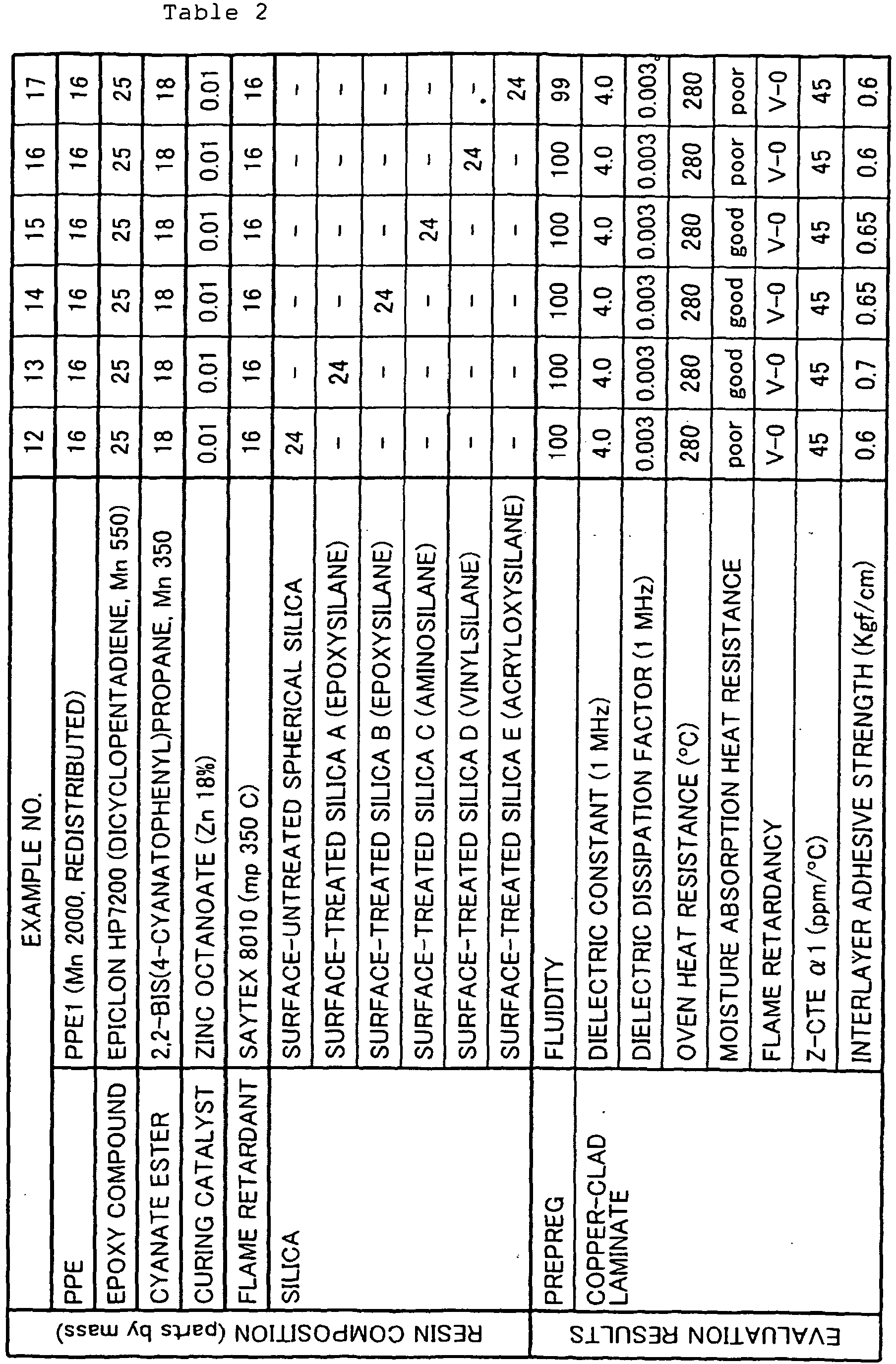

Table 1 shows that the copper-clad laminates obtained using the epoxy resin compositions of Examples 1 to 11 of the present embodiment all had heat resistance of 260°C or greater, and flame retardancy of V-0. The following can also be seen from a comparison of the evaluations of Examples 1 to 3, in which the compositions were the same except for the flame retardants having different melting points. In the case using the epoxy resin compositions of Examples 1 and 2, in which the flame retardant had a melting point of 300°C or higher, oven heat resistance was high (270°C). However, in the case using the epoxy resin composition of Example 3, in which the flame retardant had a melting point of 225°C, oven heat resistance was somewhat lower (260°C). Comparing Example 1 using PPE obtained by a redistribution reaction and Example 7 using PPE obtained by a polymerization reaction, heat resistance was higher in Example 1. Heat resistance was also low in Comparative Examples 1 and 2, which used solvent-soluble halogen flame retardants. The heat resistance of the copper-clad laminate was also low in Comparative Example 3 using a brominated epoxy compound and in Comparative Example 4 using brominated polystyrene.

Table 2 shows that the laminates of Examples 13 and 14, which used epoxy resin compositions compounded with inorganic fillers that had been surface-treated with epoxysilane type silane coupling agents, and Example 15, which used an epoxy resin composition compounded with an inorganic filler that had been surface-treated with an aminosilane type silane coupling agent, had excellent moisture absorption heat resistance and high interlayer adhesive strength. On the other hand, heat resistance during moisture absorption was somewhat lower in the case of the laminates of Example 12, which used an epoxy resin composition compounded with a surface-untreated inorganic filler, and Examples 16 and 17, which used epoxy resin compositions compounded with inorganic fillers that had been treated with vinylsilane or acryloxysilane type silane coupling agents.

As explained in detail above, one aspect of the present invention is an epoxy resin composition composed of a resin varnish containing (A) an epoxy compound having a number-average molecular weight of 1000 or less and containing at least two epoxy groups in the molecule without containing any halogen atoms, (B) a polyphenylene ether having a number-average molecular weight of 5000 or less, (C) a cyanate ester compound, (D) a curing catalyst and (E) a halogen flame retardant, wherein all of the components (A) to (C) are dissolved in the resin varnish, while the component (E) is dispersed without being dissolved in the resin varnish. With this configuration, dissociation of halogens during heating is suppressed through the use of the halogen flame retardant (E) that does not dissolve in the solvent of the resin varnish, making it possible to obtain a cured product that is flame retardant and highly heat resistant.

For the purpose of obtaining a cured product that is even more heat resistant, it is desirable that the halogen flame retardant (E) be at least one kind selected from the group consisting of ethylene dipentabromobenzene, ethylene bistetrabromophthalimide, decabromodiphenyl oxide, tetradecabromodiphenoxy benzene and bis(tribromophenoxy) ethane.

The halogen flame retardant with a melting point of 300°C or more and specifically at least one kind selected from the group consisting of ethylene dipentabromobenzene, ethylene bistetrabromophthalimide, decabromodiphenyl oxide and tetradecabromodipheoxy benzene for example can be used by preference as the halogen flame retardant (E) from the standpoint of obtaining particularly high heat resistance.

At least one epoxy compound selected from the group consisting of the dicyclopentadiene epoxy compounds, bisphenol F epoxy compounds, bisphenol A epoxy compounds and biphenyl epoxy compounds can be used by preference as the epoxy compound (A) from the standpoint of good compatibility with the polyphenylene ether (B).

The polyphenylene ether (B) is preferably one obtained by subjecting a polyphenylene ether with a number-average molecular weight of 10,000 to 30,000 to a redistribution reaction in a solvent in the presence of a phenol compound and a radical initiator. Still greater heat resistance can be ensured in this way because such a polyphenylene ether has at both ends of the molecular chain the hydroxyl groups derived from the phenol compound that contribute to curing.

It is desirable from the standpoint of ensuring still greater heat resistance and fluidity that the curing catalyst (D) contains an organic metal salt.

From the standpoint of flame retardancy and dimensional stability during heating, it is desirable that the epoxy resin composition contains an inorganic filler (F) which is at least one kind selected from the group consisting of spherical silica, aluminum hydroxide and magnesium hydroxide.

Spherical silica that has been treated with at least one kind of silane coupling agent selected from epoxysilane type silane coupling agents and aminosilane type silane coupling agents is desirable as the inorganic filler (F), since it tends to provide greater interlayer peel strength and greater heat resistance during moisture absorption of a metal-clad laminate obtained using the epoxy resin composition.

Another aspect of the present invention is a prepreg obtained by impregnating a fiber substrate with the aforementioned epoxy resin composition and by curing the composition.

Another aspect of the present invention is a metal-clad laminate obtained by laminating metal foil on the aforementioned prepreg and by hot press molding the laminate.

Another aspect of the present invention is a printed wiring board obtained by partially removing the metal foil from the surface of the aforementioned metal-clad laminate to thereby form circuits.

## Claims

1. An epoxy resin composition which is a thermosetting resin composition composed of a resin varnish containing (A) an epoxy compound having a number-average molecular weight of 1000 or less and containing at least two epoxy groups in the molecule without containing any halogen atoms, (B) a polyphenylene ether having a number-average molecular weight of 5000 or less, (C) a cyanate ester compound, (D) a curing catalyst and (E) a halogen flame retardant,
wherein all of the components (A) to (C) are dissolved in the resin varnish, while the component (E) is dispersed, with an average particle diameter of 0.1 to 50µm without being dissolved in the resin varnish.

2. The epoxy resin composition according to Claim 1, wherein said halogen flame retardant (E) is at least one kind selected from the group consisting of ethylene dipentabromobenzene, **ethylene bistetrabromophthalimide,** decabromodiphenyl oxide, tetradecabromodiphenoxy benzene and bis(tribromophenoxy) ethane.

3. The epoxy resin composition according to Claim 1, wherein said halogen flame retardant (E) has a melting point of 300°C or more.

4. The epoxy resin composition according to Claim 3, wherein the halogen flame retardant (E) with a melting point of 300°C or more is at least one kind selected from the group consisting of ethylene dipentabromobenzene, **ethylene bistetrabromophthalimide, decabromodiphenyl oxide and tetradecabromodiphenoxy benzene.**

5. The epoxy resin composition according to any one of Claims 1 to 4, wherein said epoxy compound (A) is at least one epoxy compound selected from dicyclopentadiene epoxy compounds, bisphenol F epoxy compounds, bisphenol A epoxy compounds and biphenyl epoxy compounds.

6. The epoxy resin composition according to any one of Claims 1 to 5, wherein said polyphenylene ether (B) is obtained by subjecting a polyphenylene ether with a number-average molecular weight of 10,000 to 30,000 to a redistribution reaction in a solvent in the presence of a phenol compound and a radical initiator.

7. The epoxy resin composition according to any one of Claims 1 to 6, wherein said curing catalyst (D) contains an organic metal salt.

8. The epoxy resin composition according to any one of Claims 1 to 7, wherein the epoxy resin composition further contains (F) an inorganic filler.

9. The epoxy resin composition according to Claim 8, wherein the inorganic filler (F) is at least one kind selected from the group consisting of spherical silica, aluminum hydroxide and magnesium hydroxide.

10. The epoxy resin composition according to Claim 9, wherein the inorganic filler (F) is spherical silica that has been treated with at least one kind of silane coupling agent selected from epoxysilane type silane coupling agents and aminosilane type silane coupling agents.

11. A prepreg obtained by impregnating a fiber substrate with the epoxy resin composition according to any one of Claim 1 to 10 and by curing the composition.

12. A metal-clad laminate obtained by laminating metal foil on the prepreg according to Claim 11 and by hot press molding the laminate.

13. A printed wiring board obtained by partially removing the metal foil from the surface of the metal-clad laminate according to Claim 12 to thereby form circuits.

## Patentansprüche

1. Epoxyharzzusammensetzung, welche eine wärmehärtende Harzzusammensetzung ist, umfassend einen Harzlack, enthaltend (A) eine Epoxyverbindung mit einem zahlenmittleren Molekulargewicht von 1000 oder weniger und enthaltend mindestens zwei Epoxygruppen in dem Molekül, ohne jedwede Halogenatome zu enthalten, (B) einen Polyphenylenether mit einem zahlenmittleren Molekulargewicht von 5000 oder weniger, (C) eine Cyanatesterverbindung, (D) einen Härtungskatalysator und (E) ein Halogen-Flammschutzmittel,
wobei sämtliche der Komponenten (A) bis (C) in dem Harzlack gelöst sind, während die Komponente (E) mit einem durchschnittlichen Teilchendurchmesser von 0,1 bis 50 µm dispergiert ist, ohne in dem Harzlack gelöst zu sein.

2. Epoxyharzzusammensetzung gemäß Anspruch 1, wobei das Halogen-Flammschutzmittel (E) mindestens ein Mittel ist, ausgewählt aus der Gruppe, bestehend aus Ethylendipentabrombenzol, Ethylenbistetrabromphthalimid, Decabromdiphenyloxid, Tetradecabromdiphenoxybenzol und Bis(tribromphenoxy)ethan.

3. Epoxyharzzusammensetzung gemäß Anspruch 1, wobei das Halogen-Flammschutzmittel (E) einen Schmelzpunkt von 300°C oder mehr aufweist.

4. Epoxyharzzusammensetzung gemäß Anspruch 3, wobei das Halogen-Flammschutzmittel (E) mit einem Schmelzpunkt von 300°C oder mehr mindestens ein Mittel ist, ausgewählt aus der Gruppe, bestehend aus Ethylendipentabrombenzol, Ethylenbistetrabromphthalimid, Decabromdiphenyloxid und Tetradecabromdiphenoxybenzol.

5. Epoxyharzzusammensetzung gemäß einem der Ansprüche 1 bis 4, wobei die Epoxyverbindung (A) mindestens eine Epoxyverbindung ist, ausgewählt aus Dicyclopentadienepoxyverbindungen, Bisphenol-F-Epoxyverbindungen, Bisphenol-A-Epoxyverbindungen und Biphenylepoxyverbindungen.

6. Epoxyharzzusammensetzung gemäß einem der Ansprüche 1 bis 5, wobei der Polyphenylenether (B) durch Unterwerfen eines Polyphenylethers mit einem zahlenmittleren Molekulargewicht von 10.000 bis 30.000 einer Redistributionsreaktion in einem Lösungsmittel in der Gegenwart einer Phenolverbindung und eines radikalischen Initiators erhalten wird.

7. Epoxyharzzusammensetzung gemäß einem der Ansprüche 1 bis 6, wobei der Härtungskatalysator (D) ein organisches Metallsalz enthält.

8. Epoxyharzzusammensetzung gemäß einem der Ansprüche 1 bis 7, wobei die Epoxyharzzusammensetzung weiter (F) ein anorganisches Füllmittel enthält.

9. Epoxyharzzusammensetzung gemäß Anspruch 1, wobei das anorganische Füllmittel (F) mindestens ein Mittel ist, ausgewählt aus der Gruppe, bestehend aus kugelförmigem Silica, Aluminiumhydroxid und Magnesiumhydroxid.

10. Epoxyharzzusammensetzung gemäß Anspruch 9, wobei das anorganische Füllmittel (F) kugelförmiges Silica ist, welches mit mindestens einer Art von Silankupplungsmittel, ausgewählt aus Silankupplungsmittel vom Epoxysilan-Typ und Silankupplungsmittel vom Aminosilan-Typ, behandelt worden ist.

11. Prepreg, erhalten durch Imprägnieren eines Fasersubstrats mit der Epoxyharzzusammensetzung gemäß einem der Ansprüche 1 bis 10 und durch Härten der Zusammensetzung.

12. Metall-kaschiertes Laminat, erhalten durch Laminieren von Metallfolie auf das Prepreg gemäß Anspruch 11 und Warmformpressen des Laminats.

13. Gedruckte Leiterplatte, erhalten durch teilweises Entfernen der Metallfolie von der Oberfläche des Metall-kaschierten Laminats gemäß Anspruch 11, um dadurch Schaltkreise zu bilden.

## Revendications

1. Composition de résine époxy qui est une composition de résine thermodurcissable composée d'un vernis de résine contenant (A) un composé époxy ayant une masse moléculaire moyenne en nombre de 1 000 ou moins et contenant au moins deux groupes époxy dans la molécule sans contenir aucun atome d'halogène, (B) un poly(phénylène éther) ayant une masse moléculaire moyenne en nombre de 5 000 ou moins, (C) un composé cyanate ester, (D) un catalyseur de durcissement et (E) un ignifuge halogène,
dans laquelle tous les composants (A) à (C) sont dissous dans le vernis de résine, alors que le composant (E) est dispersé avec un diamètre de particule moyen de 0,1 à 50 µm sans être dissous dans le vernis de résine.

2. Composition de résine époxy selon la revendication 1, dans laquelle ledit ignifuge halogène (E) est au moins d'un type choisi dans le groupe constitué par le dipentabromobenzène d'éthylène, le bistétrabromophtalimide d'éthylène, l'oxyde de décabromodiphényle, le benzène de tétradécabromodiphénoxy et l'éthane de bis(tribromophénoxy).

3. Composition de résine époxy selon la revendication 1, dans laquelle ledit ignifuge halogène (E) a un point de fusion de 300 °C ou plus.

4. Composition de résine époxy selon la revendication 3, dans laquelle l'ignifuge halogène (E) avec un point de fusion de 300 °C ou plus est au moins d'un type choisi dans le groupe constitué par le dipentabromobenzène d'éthylène, le bistétrabromophtalimide d'éthylène, l'oxyde de décabromodiphényle, et le benzène de tétradécabromodiphénoxy.

5. Composition de résine époxy selon l'une quelconque des revendications 1 à 4, dans laquelle ledit composé époxy (A) est au moins un composé époxy choisi parmi les composés époxy dicyclopentadiène, les composés époxy bisphénol F, les composés époxy bisphénol A et les composés époxy biphényle.

6. Composition de résine époxy selon l'une quelconque des revendications 1 à 5, dans laquelle ledit poly(phénylène éther) (B) est obtenu en soumettant un poly(phénylène éther) ayant une masse moléculaire moyenne en nombre de 10 000 à 30 000 à une réaction de redistribution dans un solvant en présence d'un composé phénol et d'un initiateur de radicaux.

7. Composition de résine époxy selon l'une quelconque des revendications 1 à 6, dans laquelle ledit catalyseur de durcissement (D) contient un sel de métal organique.

8. Composition de résine époxy selon l'une quelconque des revendications 1 à 7, dans laquelle la composition de résine époxy contient en outre (F) une charge inorganique.

9. Composition de résine époxy selon la revendication 8, dans laquelle la charge inorganique (F) est au moins d'un type sélectionné dans le groupe constitué par la silice sphérique, l'hydroxyde d'aluminium et l'hydroxyde de magnésium.

10. Composition de résine époxy selon la revendication 9, dans laquelle la charge inorganique (F) est de la silice sphérique qui a été traitée avec au moins un type d'agent de couplage au silane choisi parmi les agents de couplage au silane de type époxysilane et les agents de coulage au silane de type aminosilane.

11. Préimprégné obtenu en imprégnant un substrat de fibres avec la composition de résine époxy selon l'une quelconque des revendications 1 à 10 et en faisant durcir la composition.

12. Stratifié revêtu de métal obtenu en stratifiant une feuille de métal sur le préimprégné selon la revendication 11 et en moulant par pressage à chaud le stratifié.

13. Tableau de connexion imprimé obtenu en retirant partiellement la feuille de métal de la surface du stratifié revêtu de métal selon la revendication 12 afin de former ainsi des circuits.
